(19) Europäisches Patentamt
European Patent Office
Office européen des brevets

(11) **EP 2 154 760 A2**

(12) **EUROPÄISCHE PATENTANMELDUNG**

(43) Veröffentlichungstag:
**17.02.2010 Patentblatt 2010/07**

(51) Int Cl.:
*H01S 5/026* (2006.01)   *H01S 5/12* (2006.01)
*H01S 5/36* (2006.01)   *H01L 33/00* (2010.01)

(21) Anmeldenummer: **09009312.1**

(22) Anmeldetag: **17.07.2009**

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**AL BA RS**

(30) Priorität: **13.08.2008 DE 102008038993**

(71) Anmelder: **Karlsruher Institut für Technologie 76131 Karlsruhe (DE)**

(72) Erfinder:
• **Mappes, Timo, Dr.**
  **76135 Karlsruhe (DE)**
• **Vannahme, Christoph**
  **76139 Karlsruhe (DE)**
• **Schelb, Mauno**
  **76131 Karlsruhe (DE)**

(54) **Optisches Element und Verfahren zu seiner Herstellung**

(57) Die Erfindung betrifft ein optisches Element und ein Verfahren zu seiner Herstellung.

Das optische Element umfasst ein Substrat **1,** in das ein passiver Wellenleiter **10,** der eine Dicke D und eine obere Kante **11** aufweist, und ein Laserwellenleiter **20,** der eine Dicke d und eine obere Kante **21** aufweist, eingebracht sind, wobei der passive Wellenleiter **10** und der Laserwellenleiter **20** über eine Verbindungsfläche **15** derart in direktem Kontakt zueinander stehen, dass zwischen dem passiven Wellenleiter **10** und dem Laserwel-lenleiter **20** Stirnkopplung besteht, und zwischen der oberen Kante **11** des passiven Wellenleiters **10** und der oberen Kante **21** des Laserwellenleiters **20** ein Absatz **25,** der eine Höhe H aufweist, vorgesehen ist.

Zwischen dem passivem Wellenleiter **10** und dem Laserwellenleiter **20** besteht eine wesentlich verbesserte Kopplung. Damit wird das technische Problem der Einkopplung von Laserlicht in die im Substrat **1** integrierten Wellenleiter **10, 10', 20** gelöst. Eine Abdeckung **30** schont das Lasermaterial.

# Fig. 2

EP 2 154 760 A2

## Beschreibung

Die Erfindung betrifft ein optisches Element, umfassend ein Substrat, in das ein passiver Wellenleiter und ein Laserwellenleiter eingebracht sind, und ein Verfahren zu seiner Herstellung.

Aus V. G. Kozlov, V. Bulovic, P. E. Burrows, S. R. Forrest, Laser action in organic semiconductor waveguide and doubleheterostructure devices, Nature, Band 389, S. 362-364, 1997, sind Laserwellenleiter für organische Halbleiterlaser mit einem optischen Gitter bekannt, das für die verteilte Rückkopplung des Laserlichts sorgt und das daher als distributed feedback grating oder als DFB-Gitter bezeichnet wird. Bei DFB-Gittern handelt es sich um periodische Strukturen mit Abmessungen in der Größenordnung von 10 nm bis 1 $\mu$m, die in das Substrat eingefügt sind. Im einfachsten Fall wird hierfür ein periodisches Liniengitter in das Substrat eingebracht.

Nach V.G. Kozlov, V. Bulovic, P.E. Burrows, M. Baldo, V.B. Khalfin, G. Parthasarathy, S.R. Forrest, Y. You, M.E. Thompson, Study of lasing action based on Forster energy transfer in optically pumped organic semiconductor thin films, J. Appl. Phys., Band 84, S. 4096-4108, 1998 ist die Lebensdauer von organischen Halbleiterlasern hauptsächlich durch Oxidation begrenzt. Daher erfordert der Betrieb eines derartigen organischen Halbleiterlasers in der Praxis eine Kapselung der Laser-Farbstoffe, um eine Photooxidation des Laser-Farbstoffs mit Luftsauerstoff zu vermeiden. Eine hierfür geeignete Abdeckung lässt sich gemäß J. Haisma, N. Hattu, J. T. C. M. Pulles, E. Steding, J. C. G. Vervest, Direct bonding and beyond, Appl. Opt., Band 46, S. 6793-6803, 2007 mittels Bonden mit einem Substrat, auf dem der organische Halbleiterlaser aufgebracht ist, befestigen.

In M. Stroisch, Organische Halbleiterlaser auf Basis Photonischer-Kristalle, Dissertation, Universität Karlsruhe, 2007, wird beschrieben, wie organische Halbleiterlaser auf unterschiedlichen Substraten, darunter auch Polymer-Substraten, hergestellt werden können.

M. Punke, Organische Halbleiterbauelemente für mikrooptische Systeme, Dissertation, Universität Karlsruhe, 2007, setzt für den organischen Halbleiterlaser ein Substrat aus Polymethylmethacrylat (PMMA) mit UV-induzierten Wellenleitern, wie sie z. B. in P. Henzi, D.G. Rabus, U. Wallrabe, J. Mohr, Fabrication of Photonic Integrated Circuits by DUV-induced Modification of Polymers, Proc. SPIE 5451, S. 24-31, 2004 beschrieben werden, ein. Die Einkopplung des Laserlichts in den passiven Wellenleiter erfolgt hier durch evaneszente Feldkopplung. Auf diese Weise lässt sich zwar Laserlicht in die Wellenleiter einkoppeln, allerdings zeigen Simulationen, dass die übergekoppelte Leistung in einen Multimodenwellenleiter maximal bei ca. 30% liegt. Außerdem ist hierbei eine Abdeckung der Anordnung ausgeschlossen, da die Laserschicht auf dem Substrat aufgedampft wird und die dadurch erzeugten Höhenunterschiede auf dem Substrat das Aufbringen einer Abdeckung verhindern.

Ausgehend hiervon ist es die Aufgabe der vorliegenden Erfindung, ein optisches Element und ein Verfahren zu seiner Herstellung vorzuschlagen, die die vorher genannten Nachteile und Einschränkungen nicht aufweisen.

Insbesondere soll hierbei das technische Problem der Kopplung von Laserlicht in einen in ein Substrat integrierten Wellenleiter und gleichzeitig das Problem der Beanspruchung eines organischen Lasers durch Luftsauerstoff gelöst werden.

Diese Aufgabe wird im Hinblick auf das optische Element durch die Merkmale des Anspruchs 1 und im Hinblick auf ein Verfahren zur Herstellung des optischen Elements durch die Verfahrensschritte des Anspruchs 12 gelöst. Die Unteransprüche beschreiben jeweils vorteilhafte Ausgestaltungen der Erfindung.

Ein erfindungsgemäßes optisches Element enthält ein Substrat, in das ein passiver Wellenleiter, der eine Dicke D und eine obere Kante aufweist, eingebracht ist. Hierbei ist die Dicke D wie üblich dadurch definiert, dass die Änderung der Brechzahl im passiven Wellenleiter, die ihr Maximum an der oberen Kante des Wellenleiters aufweist, gegenüber dem Substrat auf einen Wert von 1/e abgefallen ist, wobei e die Eulersche Zahl ist.

Als Substrat eignen sich transparente Materialien, insbesondere Polymere, Gläser oder kristalline Materialien, vorzugsweise Polymethylmethacrylat (PMMA). Das Substratmaterial muss einen niedrigeren Brechungsindex haben als der passive Wellenleiter, damit darin Laserlicht geführt wird.

Weiterhin ist in das Substrat ein Laserwellenleiter, der eine Dicke d und eine obere Kante aufweist, eingebracht. Der Laserwellenleiter weist ein optisches DFB-Gitter auf, das für die verteilte Rückkopplung des Laserlichts sorgt. Hierbei handelt es sich um in das Substrat eingefügte periodische Strukturen mit Abmessungen in der Größenordnung von 10 nm bis 1 $\mu$m; im einfachsten Fall ein periodisches Liniengitter. Als aktive Lasermaterialien werden vorzugsweise organische Halbleiter genutzt.

Erfindungsgemäß berühren sich der passive Wellenleiter und der Laserwellenleiter in einer gemeinsamen Verbindungsfläche derart, dass sich zwischen dem passiven Wellenleiter und dem Laserwellenleiter Stirnkopplung ausbildet.

Stirnkopplung (engl. butt coupling) liegt nach S. Sinzinger und J. Jahns, Microoptics, 2 Aufl., WILEY-VCH, Weinheim, 2003, S. 183 dann vor, wenn zwei Wellenleiter derart in engen Kontakt zueinander stehen, dass eine Mode, die sich im ersten Wellenleiter ausbreitet, durch eine Verbindungsfläche kontinuierlich in den zweiten Wellenleiter propagiert.

Der passive Wellenleiter und der Laserwellenleiter stehen also über die Verbindungsfläche derart in direktem Kontakt zueinander, dass sich die Mode(n) im passiven Wellenleiter und die Mode(n) im Laserwellenleiter maximal überlappen. Dies insbesondere wird dann erreicht, wenn der Abstand δ der Maxima der Grundmoden in den beiden Wellenleitern möglichst gering ist, vorzugsweise gilt die Beziehung

$$\delta \leq d/2,$$

wobei d die mittlere Dicke des Laserwellenleiters bedeutet.

Erfindungsgemäß ist im Falle von monomodigen Wellenleitern, d.h. Wellenleiter, in denen sich lediglich die Grundmode ausbreitet, der Brechungsindexsprung zwischen dem Laserwellenleiter (Kern des Laserwellenleiters) und seiner Umgebung größer als der Brechungsindexsprung zwischen dem passiven Wellenleiter (Kern des passiven Wellenleiters) und seiner Umgebung. Diese Tatsache hat zur Folge, dass für die monomodigen Wellenleiter die Ausdehnung der geführten Mode im passiven Wellenleiter größer als im Laserwellenleiter ist. Daher liegt im passiven Wellenleiter das Maximum der Feldverteilung weiter von der oberen Wellenleitergrenze entfernt.

Um eine besseren Kopplung zwischen dem passiven Wellenleiter und dem Laserwellenleiter zu erzielen, ist es daher besonders vorteilhaft, den passiven Wellenleiter und den Laserwellenleiter derart zueinander anzuordnen, dass die Berandung des passiven Wellenleiters über die Berandung des Laserwellenleiters hinausreicht. Erst eine derartige Anordnung ermöglicht die Abdeckung des Lasers durch Anbringen eines Deckels auf dem passiven Wellenleiter.

Handelt es sich beim passiven Wellenleiter jedoch um einen Multimodewellenleiter, dessen Kern weiter ausgedehnt ist als der des Laserwellenleiters, entfällt die Bedingung, dass der Brechzahlsprung im passiven Wellenleiter größer sein muss als im Laserwellenleiter.

Erfindungsgemäß sind der passive Wellenleiter und der Laserwellenleiter daher so zueinander angeordnet, dass sich zwischen der oberen Kante des passiven Wellenleiters und der oberen Kante des Laserwellenleiters ein Absatz der Höhe H ausbildet, wobei für H die Beziehung

$$0 \leq H \leq D-d$$

gilt, wobei ≤ kleiner oder gleich bedeutet.

In einer bevorzugten Ausgestaltung weist die Dicke D des passiven Wellenleiters einen Wert von 1 μm bis 100 μm und die mittlere Dicke d des Laserwellenleiters einen Wert von 0,1 μm bis 1 μm auf.

In einer besonders bevorzugten Ausgestaltung weist die Dicke D des passiven Wellenleiters einen Wert von 4 μm bis 50 μm und die Dicke d des Laserwellenleiters einen Wert von 0,1 μm bis 0,4 μm auf. In dieser Ausgestaltung ist bei den meisten Laserwellenleitern, die auf ein Substrat aus PMMA aufgebracht sind, bei der Einkopplung von Laserlicht im sichtbaren Bereich sichergestellt, dass sich nur eine Mode im Laserwellenleiter ausbreitet (monomodiger Wellenleiter).

Erfindungsgemäß ist demnach auf der oberen Kante des passiven Wellenleiters derart eine Abdeckung aufgebracht, dass das Substrat und die Abdeckung zusammen den passiven Wellenleiter seitlich derart umschließen, dass diese einen Mantel mit geringerer Brechzahl für den passiven Wellenleiter darstellen.

Als Material für die Abdeckung wird ein transparentes Material, insbesondere Polymer oder Glas gewählt. Bei dessen Auswahl ist darauf zu achten, dass der optische Brechungsindex des passiven Wellenleiters höher ist als der Brechungsindex der von Substrat und Abdeckung gebildeten Umgebung. Nur auf diese Weise ist die Funktionsweise eines optischen Wellenleiters, der auf dem Prinzip der Totalreflexion basiert, gewährleistet.

Die Abdeckung ist weiterhin derart angeordnet, dass zwischen der oberen Kante des Laserwellenleiters und der unteren Kante der Abdeckung ein Hohlraum gebildet wird, der vorzugsweise mit Inertgas gefüllt oder evakuiert ist. Dadurch wird eine mögliche Oxidation des Materials des Laserwellenleiters verhindert.

In einer bevorzugten Ausgestaltung wird ein optisches Element aus den folgenden Materialien vorgeschlagen:

- Das Substrat besteht aus Polymethylmethacrylat.
- In das Substrat sind ein oder mehrere passive Wellenleiter mittels UV-Bestrahlung eingebracht.
- Auf die oberen Kanten der passiven Wellenleiter ist eine Abdeckung aus Polymethylmethacrylat aufgebracht.

In das Substrat sind weiterhin ein oder mehrere Laserwellenleiter, die jeweils eine organische Halbleiter-Schicht als laseraktive Schicht enthalten, aufgebracht.

Der Laserwellenleiter besteht vorzugsweise aus einem Wirtsmaterial, in das laseraktive Gastmoleküle eingebracht sind, oder aus einem konjugierten Polymer.

Organische Halbleitermaterialien, die als Gast-Wirt-System hauptsächlich über Förster-Energie-Transfer funktionieren, erfordern eine kontrollierte Zusammensetzung der Stoffanteile. Bevorzugt wird das Gast-Wirt-System Alq3:DCM eingesetzt, wobei Alq3 für das Wirtsmaterial Aluminium-tris-(8-hydroxychinonlin) und DCM für das Gastmolekül 4-dicyanomethylen-2-methyl-6-(p-dimethylaminostyryl)-4H-pyran stehen.

Als konjugiertes Polymer wird bevorzugt eines der folgenden Polymere ausgewählt:

- MEH-PPV, d.h. 1- (3-(methoxycarbonyl) propyl)-1-phenyl,
- BN-PFO, wobei BN für 2,7-(9,9'-dioctylfluoren) und PFO für 6,6'-(2,2'-octyloxy-1,1'-binaphthyl) stehen, oder

- F8DP, d.h. Poly(9,9'-dioctylfluoren-co-9,9'-di(4-methoxy) phenylfluoren).

Eine erfindungsgemäße Vorrichtung lässt sich mit dem folgenden Verfahren herstellen.

Gemäß Verfahrensschritt a) wird zunächst ein optisches Gitter erster Ordnung mit Strukturgrößen im Bereich von 100 nm für den vorgesehenen (späteren) Laserwellenleiter strukturiert. Die Strukturierung erfolgt insbesondere mittels Elektronenstrahl-Lithographie, direktem Laserschreiben, Laserinterferenz-Lithographie in einem photoempfindliches Material oder Selbstorganisation. Die Struktur kann mittels Ätzen in ein Glas oder ein kristallines Material wie Silizium oder eine geeignete Siliziumverbindung wie $SiO_2$ übertragen werden.

Anschließend wird gemäß Verfahrensschritt b) ein Photolack auf das in Verfahrensschritt a) hergestellte optische Gitter aufgebracht, wobei die Dicke des Photolacks auf einen Wert von d + H eingestellt wird. Hierbei bedeutet d die Dicke des späteren Laserwellenleiters und H die Höhe des späteren Absatzes zwischen der oberen Kante des späteren passiven Wellenleiters und der oberen Kante des späteren Laserwellenleiters.

Im sich hierzu anschließenden Verfahrensschritt c) wird der Photolack (Photoresist) mittels Lithographie in einem Bereich oberhalb des optischen Gitters entfernt, wodurch eine Urform (70) gebildet wird, die bereits den Absatz (Stufe) zur Senkung der Ebene des aktiven Wellenleiters gegenüber dem passiven Wellenleiter enthält.

Aus der nun vollendeten Urform wird gemäß Verfahrensschritt d) über Galvanik ein Metall-Werkzeug als topologische Negativform hergestellt. Dieses Werkzeug wird dann in Verfahrensschritt e) in ein Substrat durch Heißprägen abgeformt.

Dann werden in Verfahrensschritt f) ein oder mehrere passive Wellenleiter vorzugsweise mittels Eindiffusion, Dotierung, Aufbringen von Materialien oder Bestrahlung im Substrat gebildet. Hierbei müssen sich der passive Wellenleiter und der spätere Laserwellenleiter über eine Verbindungsfläche direkt berühren. Die Anordnung muss so erfolgen, dass zwischen dem passiven Wellenleiter und dem späteren Laserwellenleiter die Stirnkopplung ermöglicht wird.

Danach wird gemäß Verfahrensschritt g) mindestens ein Laserwellenleiter durch Aufbringen eines Lasermaterials auf die abgeformten Strukturen des optischen Gitters hergestellt. Das Aufbringen des Lasermaterials erfolgt vorzugsweise mittels Inkjet-Drucken, Aufschleudern in Lösung oder einem Koverdampfungsverfahren. Organische Halbleiter-Materialien, die als Gast-Wirt-System hauptsächlich über Förster-Energie-Transfer funktionieren, erfordern eine kontrollierte Zusammensetzung der Stoffanteile.

Schließlich wird im Anschluss an den Verfahrensschritt g) im Verfahrensschritt h) eine Abdeckung auf die obere Kante des mindestens einen passiven Wellenleiters aufgebracht, so dass sich zwischen der unteren Kante der Abdeckung und oberen Kante des Laserwellenleiters eine sauerstofflose Umgebung in Form eines Hohlraums ausbildet. Die auf diese Weise erfolgte Kapselung des organischen Lasers vermeidet Photooxidationsprozesse mit dem Luftsauerstoff und erhöht die Lebensdauer des Lasers, die hauptsächlich durch Oxidation begrenzt wird.

Ist die Abdeckung transparent für die entsprechende Wellenlänge ist, lässt sich der Laser durch sie hindurch optisch pumpen. Als Abdeckung eignen sich daher insbesondere ein Polymer oder ein Glas. Die Abdeckung (Deckel) selbst wird durch Kleben oder (thermisches) Bonden mit dem Substrat verbunden.

Eine erfindungsgemäße Vorrichtung lässt sich in der integrierten Optik anwenden. Sie lässt sich insbesondere in Verbindung mit einem Wechselwirkungsbereich, der einen Analyten umfasst, als optischer Sensor einsetzen.

Die Erfindung weist insbesondere die im Folgenden erwähnten Vorteile auf.

Zwischen dem aktivem Wellenleiter (Laserwellenleiter) und dem passivem Wellenleiter besteht eine wesentlich verbesserte Kopplung. Damit wird das technische Problem der Einkopplung von Laserlicht in die im Substrat integrierten Wellenleiter gelöst.

Durch den erfindungsgemäßen Aufbau des optischen Elements wird es möglich auf den Laser eine Abdeckung anzubringen, die das Lasermaterial insbesondere vor Oxidationsprozessen schont.

Die Erfindung wird im Folgenden anhand eines Ausführungsbeispiels und den Figuren näher erläutert. Hierbei zeigen:

Fig. 1: Optisches Element aus einem Substrat mit zwei organischen Halbleiterlasern und zwei passiven Wellenleitern ohne Abdeckung.

Fig. 2: Schematische Darstellung der Einkopplung von Laserlicht aus dem organischen Halbleiterlaser in den passiven Wellenleiter mit Abdeckung.

Fig. 3: Anpassung der Modenposition für maximalen Überlapp der Wellenleitermoden a) im passiven Wellenleiter und b) im Laserwellenleiter.

Fig. 4: Erfindungsgemäßes Verfahren zur Herstellung eines optischen Elements mit Abdeckkung.

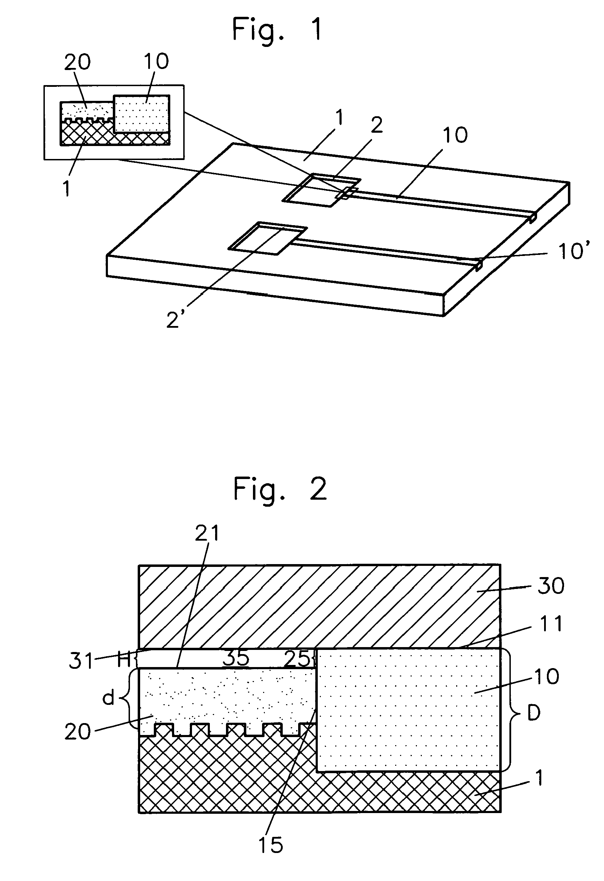

Fig. 1 zeigt ein Substrat 1 aus Polymethylmethacrylat (PMMA), worin mittels UV-Bestrahlung zwei passive Wellenleiter 10, 10' eingebracht wurden, die jeweils mit einem organischen Halbleiterlaser 2, 2' verbunden sind. Jeder der beiden organischen Halbleiterlaser 2, 2' weist einen Laserwellenleiter 20 auf, der aus einer organischen Halbleiter-Schicht in Form eines DFB-Gitters besteht. Für die organische Halbleiter-Schicht wurde das Gast-Wirt-System $Alq_3$:DCM eingesetzt.

In **Fig. 1** sind der Laserwellenleiter 20 als Schicht-Wellenleiter und die passiven Wellenleiter 10, 10' als Streifen-Wellenleiter ausgeführt. Im Allgemeinen lassen sich jedoch sowohl der Laserwellenleiter 20 als auch die passiven Wellenleiter 10, 10' als Streifen- oder als Schicht-Wellenleiter ausführen.

Gemäß **Fig. 2** ist der Laserwellenleiter 20 in Bezug zu dem zugehörigen passiven Wellenleiter 10 derart angeordnet, dass das Laserlicht über eine Verbindungsfläche 15 mittels Stirnkopplung vom Laserwellenleiter 20 zum betreffenden passiven Wellenleiter 10 führbar ist. Die passiven Wellenleiter 10, 10' werden durch UV-Induzierung in PMMA erzeugt. Auf diese Weise lassen sich Wellenleiter mit einem geringem Brechzahlsprung im Vergleich zum Substrat und damit einer vergleichsweise schwachen Führung des Lichts erzeugen.

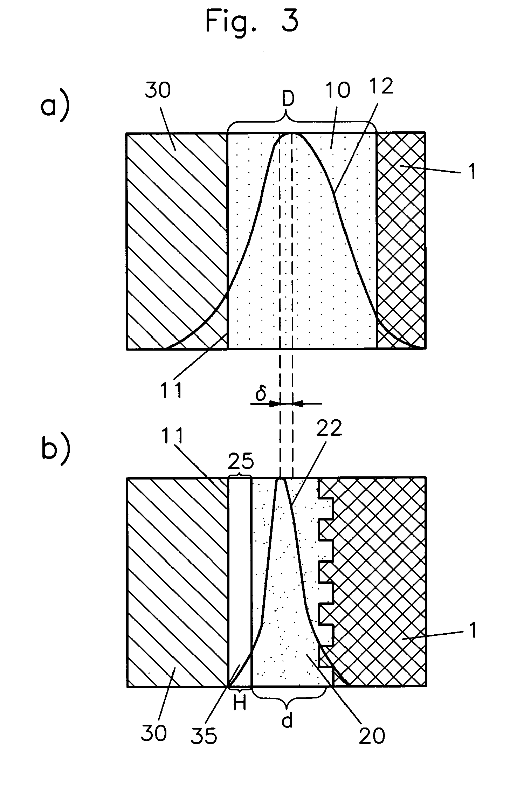

Um, wie in **Fig. 3** dargestellt, die Kopplung zwischen der Grundmode 22 des Laserwellenleiters 20 und der Grundmode 12 des zugehörigen passiven Wellenleiters 10 durch Maximierung des Überlappintegrals der beiden Grundmoden 12, 22 zu verbessern, werden der Laserwellenleiter 20 und der betreffenden passiven Wellenleiter 10 derart im Substrat angeordnet, dass zwischen ihnen ein Absatz (Stufe) 25 entsteht.

In **Fig. 3a) und b)** ist schematisch die jeweils normierte elektrische Feldstärke der beiden Grundmoden 12, 22 gegenüber dem Abstand von der oberen Kante 11 des passiven Wellenleiters 10 sowie der Abstand δ zwischen den Maxima der beiden Grundmoden 12, 22 aufgetragen. Durch die stärkere Führung des Lichts im monomodigen Laserwellenleiter 20 ist, wie in Fig. 3 b) dargestellt, die Ausdehnung der Feldverteilung kleiner als im passiven monomodigen Wellenleiter 10, 10' gemäß Fig. 3a) und der Schwerpunkt dieses Feldes liegt näher an der Oberfläche. Daher wurde ein Absatz 25 zwischen der oberen Kante 11 des passiven Wellenleiters 10 und der oberen Kante 21 des Laserwellenleiters 20 vorgesehen.

Weiterhin ist die Vorrichtung mit einer Abdeckung 30, die vorzugsweise aus PMMA besteht, oberhalb des Laserwellenleiters 20 versehen, die unmittelbar auf der Oberfläche der passiven Wellenleiter 10, 10' aufgebracht ist, wobei jedoch ein Bereich 35 zwischen der Abdeckung 30 und dem Laserwellenleiter 20 verbleibt, der mit einem inerten Gas (Stickstoff, Argon) gefüllt oder evakuiert wurde.

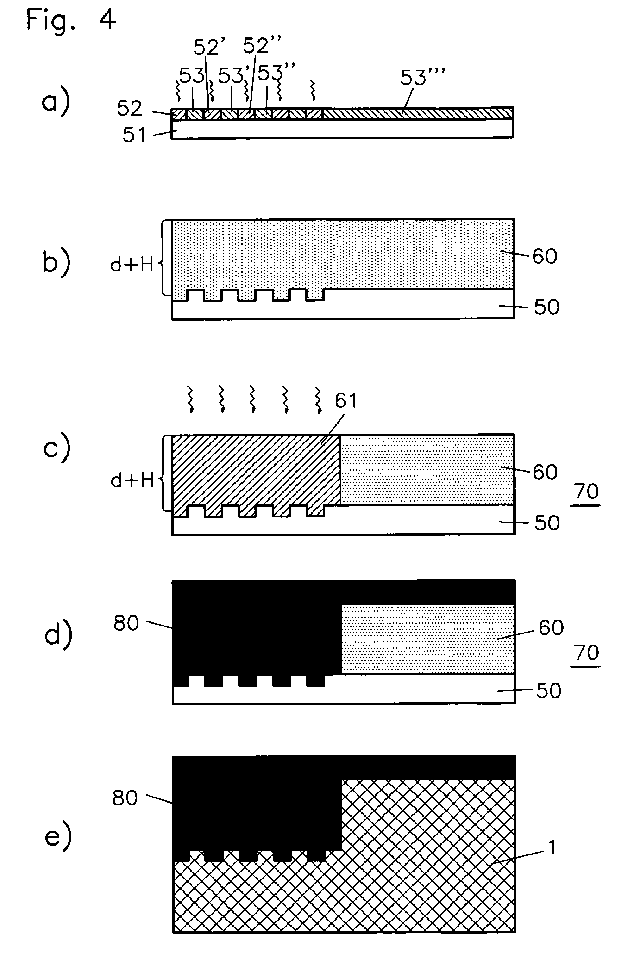

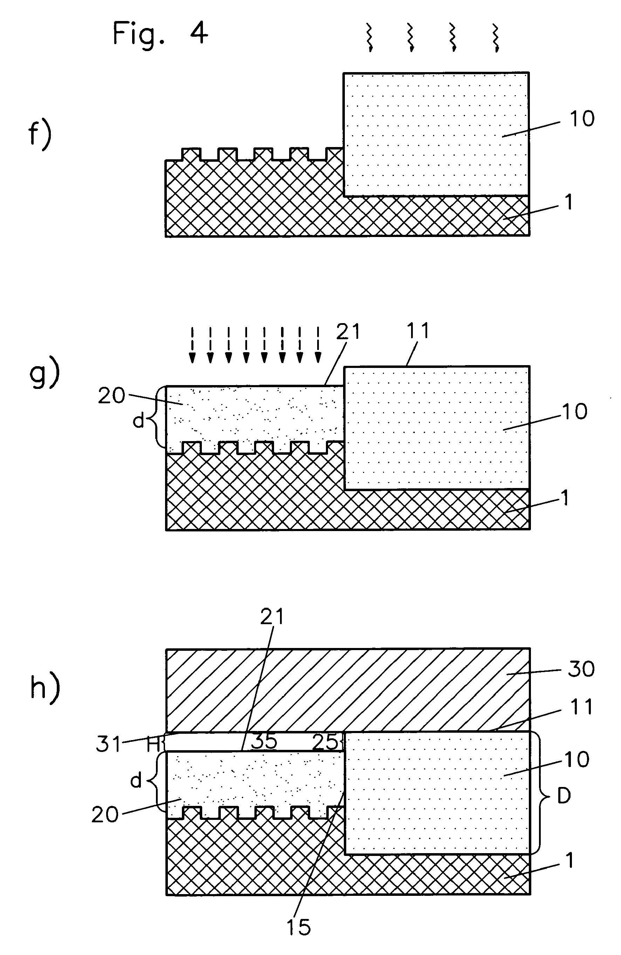

In **Fig. 4** ist ein bevorzugtes Verfahren zur Herstellung des optischen Elements schematisch dargestellt.

Das mit einem Gitter zur verteilten optischen Rückkopplung strukturierte Siliziumsubstrat 51 wurde gemäß **Fig. 4a)** über das im Folgenden beschriebene Verfahren hergestellt. Durch E-lektronenstrahllithographie ließ sich das Gitter erster Ordnung auf einem Siliziumsubstrat 51 mit oder ohne oxidierte Oberfläche entweder in Negativ- oder Positiv-Resist strukturieren. Mit dem Negativ-Resist siloxanbasiertes Wasserstoff-Silsesquioxan (engl. *siloxan-based hydrogen silsesquioxane,* HSQ) war eine Abformung in Polymere direkt möglich.

In einer alternativen Ausgestaltung wurde die lithografisch generierte Struktur in das Substrat 51 durch Ätzen übertragen. Zunächst wurde dazu ein Resist mit Elektronenstrahlen belichtet und dann entwickelt. Substrat 51 und Resist wurden mit einer Chromschicht, die dünner als der Resist war, bedampft. In einem Lift-Off-Prozess wurde das Chrom, das nicht direkt das Substrat berührte, entfernt. Das übrige Chrom diente als Ätzmaske und die Struktur wurde mittels Plasmaätzen (so genanntes *reaktives Ionenätzen)* in der gewünschten Tiefe in das Substrat übertragen. Anschließend wurde das Chrom entfernt. Alternativ diente der Positiv-Resist nach dem Entwickeln als Ätzmaske.

Anschließend wurde gemäß **Fig. 4b)** ein über dem das optische DFB-Gitter enthaltende Siliziumsubstrat 50 als Resist aufgetragener Photolack 60 belichtet und entwickelt. Die Dicke des Photolacks 60 war dabei auf einen Wert von d + H eingestellt worden, wobei d der Dicke des vorgesehenen Laserwellenleiters 20 und H der Höhe des vorgesehenen Absatzes 25 zwischen der oberen Kante 11 des vorgesehenen passiven Wellenleiters 10 und der oberen Kante 21 des vorgesehenen Laserwellenleiters 20 entsprachen.

Danach wurde gemäß **Fig. 4c)** mittels Elektronenstrahl- oder optischer Lithographie der Photolacks 60 über dem das optische DFB-Gitter enthaltende Siliziumsubstrat 50 teilweise, d.h. in einem Bereich 61 oberhalb des optischen Gitters, entfernt. Auf diese Weise wurde eine Urform 70 gebildet, aus der gemäß Fig. 4d) ein Werkzeug 80 als topologische Negativform aus der Urform 70 hergestellt wurde. Derartige Abformwerkzeuge ließen sich insbesondere galvanisch, vorzugsweise in Nickel herstellen.

Hieran anschließend wurde gemäß **Fig. 4e)** durch Abformen des Werkzeugs 80 in ein Substrat 1 das optische Gitter insbesondere durch Heißprägen in das Substrat 1 übertragen. Alternativ wurden UV-Nanoimprint-Lithographie, bei der ein Polymersubstrat durch energiereiche UV-Strahlung durch eine Maske mit einem periodischen Muster belichtet wurde, oder Formgießen eingesetzt.

Dann wurde gemäß **Fig. 4f)** der passive Wellenleiter 10 in ein Substrat 1 aus PMMA eingebracht, indem diejenigen Bereiche der Oberfläche des Substrats 1 einer UV-Bestrahlung ausgesetzt wurden, die späten den passiven Wellenleiter 10 bilden sollen. Alternative Verfahren sind Eindiffusion, Dotieren oder das Aufbringen von geeigneten Materialien auf das Substrat 1.

Unabhängig vom eingesetzten Verfahren war darauf zu achten, dass das optische Gitter derart in das Substrat 1 aus PMMA eingebracht wird, dass es später als Laserwellenleiter 20 derart über eine Verbindungsfläche 15 mit dem passiven Wellenleiter 10 in direktem Kontakt kommt, dass später zwischen dem passiven Wellenleiter 10 und dem Laserwellenleiter 20 Stirnkopplung besteht.

Danach wurde gemäß **Fig. 4g)** der Laserwellenleiter 20 durch Aufbringen eines der oben genannten Lasermaterialien auf die abgeformten Strukturen des optischen Gitters hergestellt. Zum Aufbringen des Lasermaterials wurde ein Koverdampfungsverfahren eingesetzt. Alternativ eigneten sich Inkjet-Drucken oder Aufschleudern in Lösung.

Schließlich wurde gemäß **Fig. 4h)** eine Abdeckung 30 aus PMMA mittels thermischem Bonden auf die obere Kante 11 des passiven Wellenleiters 10 aufgebracht.

Nach der Herstellung wurde das optische Element vermessen, um sicherzustellen, dass die Kopplung zwischen der Grundmode 22 des Laserwellenleiters 20 und der Grundmode 12 des zugehörigen passiven Wellenleiters 10 gemäß Fig. 3 durch Maximierung des Überlappintegrals der beiden Grundmoden 12, 22 möglichst optimal ist.

**Patentansprüche**

1. Optisches Element, umfassend ein Substrat (1), in das ein passiver Wellenleiter (10), der eine Dicke D und eine obere Kante (11) aufweist, und ein Laserwellenleiter (20), der eine mittlere Dicke d und eine obere Kante (21) aufweist, eingebracht sind, wobei der passive Wellenleiter (10) und der Laserwellenleiter (20) über eine Verbindungsfläche (15) derart in direktem Kontakt zueinander stehen, dass zwischen dem passiven Wellenleiter (10) und dem Laserwellenleiter (20) Stirnkopplung besteht, zwischen der oberen Kante (11) des passiven Wellenleiters (10) und der oberen Kante (21) des Laserwellenleiters (20) ein Absatz (25) vorgesehen ist und der passive Wellenleiter (10) derart mit einer Abdeckung (30) versehen ist, dass das Substrat (1) und die Abdeckung (30) gemeinsam einen Mantel mit geringerer Brechzahl um den passiven Wellenleiter (10) darstellen, während zwischen der oberen Kante (21) des Laserwellenleiters (20) und der unteren Kante (31) der Abdeckung (30) ein Hohlraum (35) vorhanden ist.

2. Optisches Element nach Anspruch 1, wobei die Dicke D des passiven Wellenleiters (10) 1 μm bis 100 μm und die mittlere Dicke d des Laserwellenleiters (20) 0,1 μm bis 1 μm beträgt.

3. Optisches Element nach Anspruch 1 oder 2, wobei der passive Wellenleiter (10) und der Laserwellenleiter (20) derart in direktem Kontakt zueinander stehen, dass für den Abstand δ des Maximums der Grundmode (12) im passiven Wellenleiter (10) und des Maximums der Grundmode (22) im Laserwellenleiter (20) die Beziehung δ ≤ d/2 gilt, wobei d die mittlere Dicke des Laserwellenleiters ist.

4. Optisches Element nach einem der Ansprüche 1 bis 3, die Abdeckung (30) aus einem transparenten Material besteht.

5. Optisches Element nach einem der Ansprüche 1 bis 4, wobei der Hohlraum (35) mit Inertgas gefüllt oder evakuiert ist.

6. Optisches Element nach einem der Ansprüche 1 bis 5 mit

    - einem Substrat (1) aus Polymethylmethacrylat,
    - in das der passive Wellenleiter (10) mittels UV-Bestrahlung oder Dotierung in das Substrat (1) eingebracht ist und
    - einer Abdeckung (30) aus Polymethylmethacrylat.

7. Optisches Element nach einem der Ansprüche 1 bis 6 mit einem Laserwellenleiter (20) aus einer organischen Halbleiter-Schicht.

8. Optisches Element nach Anspruch 7, wobei der Laserwellenleiter (20) aus einem Wirtsmaterial besteht, in das laseraktive Gastmoleküle eingebracht sind.

9. Optisches Element nach Anspruch 8 mit Aluminium-tris-(8-hydroxychinonlin) als Wirtsmaterial und 4-dicyanomethylen- 2- methyl- 6-(p- dimethylaminostyryl)-4H-pyran als Gastmolekül.

10. Optisches Element nach Anspruch 7, wobei der Laserwellenleiter (20) aus einem konjugierten Polymer besteht.

11. Optisches Element nach Anspruch 10 mit MEH-PPV, BN-PFO oder F8DP als konjugiertem Polymer, wobei
MEH-PPV für 1-(3-methoxycarbonyl)propyl)-1-phenyl, BN für 2,7-(9,9'-dioctylfluoren) und PFO für 6,6'-(2,2'-octyloxy-1,1'-binaphthyl) sowie F8DP für poly (9,9'- dioctylfluorenco- 9,9'- di (4- methoxy) phenylfluoren) stehen.

12. Verfahren zur Herstellung eines optischen Elements nach einem der Ansprüche 1 bis 11 mit den Schritten

    a) Strukturieren eines optischen Gitters für den vorgesehenen Laserwellenleiter (20) in ein Material (51),
    b) Aufbringen eines Photolacks (60) auf das das optische Gitter umfassende Material (50), wobei für die Dicke des Photolacks ein Wert von d + H gewählt wird, worin d der mittleren Dicke des vorgesehenen Laserwellenleiters (20) und H der mittleren Höhe des vorgesehenen Absatzes (25) zwischen der oberen Kante (11) des vorgesehenen passiven Wellenleiters (10) und der oberen Kante (21) des vorgesehenen Laserwellenleiters (20) entsprechen,

c) Entfernen des Photolacks (60) mittels Lithographie in einem Bereich (61) oberhalb des optischen Gitters, wodurch eine Urform (70) gebildet wird,

d) Herstellen eines Werkzeugs (80) als topologische Negativform aus der Urform (70),

e) Abformen des Werkzeugs (80) in ein Substrat (1), so dass der vorgesehene passive Wellenleiter (10) und der vorgesehene Laserwellenleiter (20) über eine Verbindungsfläche (15) derart in direktem Kontakt zueinander stehen, dass zwischen dem vorgesehenen passiven Wellenleiter (10) und dem vorgesehenen Laserwellenleiter (20) 7Stirnkopplung möglich wird,

f) Einbringen des passiven Wellenleiters (10) in das Substrat (1),

g) Herstellen des Laserwellenleiters (20) durch Aufbringen eines Lasermaterials auf die abgeformten Strukturen des optischen Gitters,

h) Aufbringen einer Abdeckung (30) auf die obere Kante (11) des passiven Wellenleiters (10).

13. Verfahren nach Anspruch 12, wobei in Schritt f) diejenigen Bereichen der Oberfläche des Substrats (1) einer UV-Bestrahlung ausgesetzt werden oder dotiert werden, die für den passiven Wellenleiter (10) vorgesehen sind.

# Fig. 1

# Fig. 2

# Fig. 3

a)

b)

Fig. 4

a)

52' 52''
53 53' 53''          53'''
52
51

b)

d+H                    60
                       50

c)

61
d+H                    60
                       70
                       50

d)

80                     60
                       70
                       50

e)

80                     1

# Fig. 4

f)

10

1

g)

21

11

20

d

10

1

h)

21

30

31 H    35    25    11

d                    10

20                   D

15

1

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **V. G. Kozlov ; V. Bulovic ; P. E. Burrows ; S. R. Forrest.** Laser action in organic semiconductor waveguide and doubleheterostructure devices. *Nature,* 1997, vol. 389, 362-364
- **V.G. Kozlov ; V. Bulovic ; P.E. Burrows ; M. Baldo ; V.B. Khalfin ; G. Parthasarathy ; S.R. Forrest ; Y. You ; M.E. Thompson.** Study of lasing action based on Forster energy transfer in optically pumped organic semiconductor thin films. *J. Appl. Phys.,* 1998, vol. 84, 4096-4108

- **J. Haisma ; N. Hattu ; J. T. C. M. Pulles ; E. Steding ; J. C. G. Vervest.** Direct bonding and beyond. *Appl. Opt.,* 2007, vol. 46, 6793-6803
- **P. Henzi ; D.G. Rabus ; U. Wallrabe ; J. Mohr.** Fabrication of Photonic Integrated Circuits by DUV-induced Modification of Polymers. *Proc. SPIE,* 2004, vol. 5451, 24-31
- **S. Sinzinger ; J. Jahns.** Microoptics. WILEY-VCH, 2003